# EUROPÄISCHE PATENTSCHRIFT

(11) **EP 3 408 867 B1**
(45) Veröffentlichungstag und Bekanntmachung des Hinweises auf die Patenterteilung: **30.11.2022**
(21) Anmeldenummer: 17717243.4
(22) Anmeldetag: 07.04.2017
(51) Int. Cl.: H01L 31/0216, H01L 31/0224, H01L 31/0747, C23C 14/00, C23C 14/50, C23C 16/458, H01L 21/673

(54) **VERFAHREN ZUM HERSTELLEN EINER SOLARZELLE, MIT DEM VERFAHREN HERGESTELLTE SOLARZELLE UND SUBSTRATTRÄGER**
METHOD FOR PRODUCING A SOLAR CELL, SOLAR CELL PRODUCED BY THIS METHOD AND SUBSTRATE CARRIER
PROCÉDÉ DE PRODUCTION D'UNE CELLULE SOLAIRE, CELLULE SOLAIRE PRODUITE PAR LEDIT PROCÉDÉ ET SUPPORT DE SUBSTRAT

(30) Priorität: 11.04.2016 DE 102016106563
(43) Veröffentlichungstag der Anmeldung: 05.12.2018
(60) Teilanmeldung: 22153636.0
(73) Patentinhaber: Meyer Burger (Germany) GmbH, 09337 Hohenstein-Ernstthal (DE)
(72) Erfinder: CITARELLA, Giuseppe, 09112 Chemnitz (DE); SPERLICH, Hans-Peter, 01309 Dresden (DE); KÖHLER, Gunnar, 09427 Ehrenfriedersdorf (DE); WÜNSCH, Frank, 10787 Berlin (DE); SONTAG, Detlef, 08396 Waldenburg (DE); MEHLICH, Heiko, 09127 Chemnitz (DE); KÖNIG, Marcel, 09130 Chemnitz (DE); PAPET, Pierre, 2068 Hauterive (CH)
(74) Vertreter: Steiniger, Carmen
(86) Internationale Anmeldenummer: PCT/IB2017/052013
(87) Internationale Veröffentlichungsnummer: WO 2017/178941

(56) Entgegenhaltungen:
- EP-A1- 2 662 900
- WO-A1-2014/192739
- WO-A1-2015/064634
- DE-A1-102011 006 833
- FR-A1- 3 011 982

## Beschreibung

Die vorliegende Erfindung betrifft ein Verfahren zum Herstellen einer Solarzelle mit einem Heteroübergang, einer für einen Lichteinfall vorgesehenen Vorderseite und einer gegenüber der Vorderseite befindlichen Rückseite, wobei das Verfahren die folgenden Schritte aufweist: Bereitstellen eines kristallinen Halbleitersubstrates eines ersten Leitungstyps; Ausbilden wenigstens einer ersten amorphen, nano- und/oder mikrokristallinen Halbleiterschicht oder -schichtfolge auf einer vorderseitigen Oberfläche des Halbleitersubstrates, entweder unter Ausbildung eines Vorderseitenemitters eines zweiten, zu dem ersten Leitungstyp entgegengesetzten Leitungstyps oder unter Ausbildung einer Vorderseitenoberflächenfeldlage des ersten Leitungstyps; Ausbilden wenigstens einer zweiten amorphen, nano- und/oder mikrokristallinen Halbleiterschicht oder -schichtfolge auf einer rückseitigen Oberfläche des Halbleitersubstrates, entweder unter Ausbildung einer Rückseitenoberflächenfeldlage des ersten Leitungstyps oder unter Ausbildung eines Rückseitenemitters des zweiten Leitungstyps; Ausbilden wenigstens einer elektrisch leitfähigen, transparenten Vorderseitenelektrodenschicht auf dem Vorderseitenemitter oder der Vorderseitenoberflächenfeldlage und Ausbilden wenigstens einer elektrisch leitfähigen, transparenten Rückseitenelektrodenschicht auf der Rückseitenoberflächenfeldlage oder dem Rückseitenemitter; Ausbilden einer vorderseitigen metallischen Kontaktschichtgitterstruktur zur elektrischen Kontaktierung des Vorderseitenemitters oder der Vorderseitenoberflächenfeldlage; vorderseitige PECVD-Abscheidung einer elektrisch nicht leitfähigen, transparenten dielektrischen Vorderseitendeckschicht nach Ausbilden der vorderseitigen Kontaktschichtgitterstruktur; und Ausbilden einer Rückseitenmetallisierung auf der Rückseitenelektrodenschicht.

Um eine Kontaktschichtgitterstruktur, wie beispielsweise eine Silberfingerstruktur als Sammelelektrode, auf einer transparenten dielektrischen Vorder- und/oder Rückseitendeckschicht, wie beispielsweise einer transparenten, leitfähigen Oxidschicht (TCO-Schicht), einer Solarzelle auszubilden, werden im Stand der Technik typischerweise die Silberfinger unter Verwendung einer Elektroplattierungstechnologie mit einer Maske aufgebracht, welche im Nachhinein wieder entfernt wird. Das Maskierungsmaterial als auch die mit dessen Aufbringung und Entfernung verbundenen Schritte sind kostenaufwändig und können zu unvorteilhaften Beeinflussungen der Solarzellencharakteristik führen.

Darüber hinaus besteht ein Problem von Solarzellen mit exponierter TCO-Beschichtung darin, dass sie unter Einwirkung von Feuchtigkeit, insbesondere bei erhöhter Temperatur, stark an Leistung verlieren können. Die unter Einwirkung von Feuchtigkeit auftretende (elektro)chemische Zersetzung bzw. Korrosion der TCO-Schicht führt zu einem Anstieg des Serienwiderstandes (R_{S}) und zu einer daraus folgenden Degradation des Füllfaktors (FF) der Solarzelle. Die Umwandlungseffizienz der Solarzelle (ETA) bricht stark ein. Insbesondere sogenannte bifaziale Solarzellen mit beidseitig offen liegendem TCO sind anfällig für solche Korrosionserscheinungen. Die Erfindung ist jedoch auch für Solarzellen mit monofazialer TCO-Beschichtung anwendbar.

Um die TCO-Oberfläche vor Korrosion zu schützen, kann auf das TCO eine Isolatorschicht, wie beispielsweise eine Siliziumoxid-, Siliziumnitrid- oder Siliziumoxinitridschicht aufgebracht werden. Diese muss jedoch dort, wo die TCO-Schicht elektrisch durch die Kontaktschichtgitterstruktur bzw. die Kontaktfinger kontaktiert werden soll, wieder entfernt werden oder darf in diesen Bereichen gar nicht erst abgeschieden werden. Hierfür wird typischerweise eine Maskierungstechnologie eingesetzt bzw. die über der Metallisierung abgeschiedene dielektrische Schicht durch Laserablation oder maskierte Ätzung lokal geöffnet, um Metallstrukturen aufzudrucken oder durch Plating zu erzeugen. Dies hat jedoch den Nachteil, dass durch das Öffnen der hermetischen dielektrischen Schicht potenzielle Leckpfade für ein späteres Eindringen von Feuchte geschaffen werden.

Um eine Isolatorbeschichtung auf dem TCO auszubilden und dennoch das TCO auf technologisch einfache Weise geeignet elektrisch kontaktieren zu können, wird in der Druckschrift EP 2 662 900 A1 vorgeschlagen, auf die Maskierung zu verzichten und die Kontaktschichtgitterstruktur aus einer ersten elektrisch leitfähigen Schicht aus einem Material mit einem niedrigen Schmelzpunkt und einer zweiten elektrisch leitfähigen Schicht auszubilden. Hierfür wird auf eine transparente dielektrische Vorderseitendeckschicht (TCO-Schicht) die erste elektrisch leitfähige Schicht mit dem Material mit dem niedrigen Schmelzpunkt aufgebracht, darauf ganzflächig eine Isolatorschicht abgeschieden, die erste elektrisch leitfähige Schicht durch Erhitzen aufgeschmolzen und dadurch die Isolatorschicht über der ersten leitfähigen Schicht aufgesprengt. Durch das Aufsprengen entstehen Cracks in der Isolatorschicht, in welche die daraufhin abgeschiedene zweite elektrisch leitfähige Schicht eindringen und einen elektrischen Kontakt zu der ersten elektrisch leitfähigen Schicht und damit zu der TCO-Schicht herstellen kann.

Bei dieser Technologie kommt man nicht umhin, die erste leitfähige Schicht nur an den späteren Kontaktstellen auszubilden und auch nur dort zu erhitzen. Man benötigt also auch hier mindestens eine strukturierte Abscheidung oder Strukturierung, steht zudem vor dem Problem, wie die lokale Erhitzung vorgenommen werden soll, und muss versuchen, die Temperaturbelastung der Solarzellen bei diesem Erhitzungsschritt so gering wie möglich zu halten, um die Solarzellencharakteristik nicht negativ zu beeinflussen. Aus der Druckschrift WO 2014/192739 A1 ist ein Verfahren zum Herstellen einer Solarzelle bekannt, bei dem während einer Abscheidung einer Isolierschicht eine bereits bestehende Kontaktstruktur mittels einer Metallmaske abgedeckt wird, sodass die Isolierschicht nicht auf der Kontaktstruktur abgeschieden wird.

Es ist daher die Aufgabe der vorliegenden Erfindung, ein Verfahren zum Herstellen einer Solarzelle zur Verfügung zu stellen, das auf wirklich einfache und effiziente Weise sowohl die Ausbildung eines geeigneten Feuchtigkeitsschutzes für die TCO-Schicht(en) der Solarzelle und darüber hinaus eine einfache, hochqualitative und die Solarzelleneigenschaften nicht negativ beeinflussende elektrische Kontaktierung der Solarzelle ermöglicht.

Diese Aufgabe wird durch ein Verfahren der oben genannten Gattung gelöst, bei dem für die Abscheidung der Vorderseitendeckschicht eine oberflächenselektive PECVD-Abscheidung oder Hotwire-CVD verwendet und die Vorderseitendeckschicht mit einer solchen Dicke abgeschieden wird, dass die Vorderseitendeckschicht direkt nach ihrer Schichtabscheidung, ohne zusätzliche Wärme- und/oder chemische Behandlung nur auf den die vorderseitige Kontaktschichtgitterstruktur umgebenden Bereichen, aber nicht auf der vorderseitigen Kontaktschichtgitterstruktur eine geschlossene Schicht ausbildet, wobei die elektrisch leitfähige, transparente Vorderseitenelektrodenschicht eine TCO-Schicht ist, für die Ausbildung der vorderseitigen Kontaktschichtgitterstruktur ein Material ausgewählt wird, das überwiegend aus Silber oder aus Kupfer besteht und als Fingerstruktur unter Verwendung einer Paste gedruckt wird; für die Abscheidung der Vorderseitendeckschicht wenigstens eine SiOₓ-, SiNₓ-, SiOₓN_{y}-Schicht oder eine aus einer Kombination aus wenigstens zwei der vorgenannten Materialien bestehende Schicht oder Schichtfolge verwendet wird; die Vorderseitendeckschicht unter Verwendung einer Silanchemie abgeschieden wird; und die Vorderseitendeckschicht in einem Temperaturbereich zwischen 50 °C und 250 °C abgeschieden wird.

Überraschenderweise hat sich herausgestellt, dass sich die Vorderseitendeckschicht bei einer PECVD-Abscheidung zunächst nur auf der elektrisch leitfähigen, transparenten Vorderseitenelektrodenschicht und nicht bzw. nur minimal auf der Kontaktschichtgitterstruktur, also oberflächenselektiv, abscheidet. Damit kann die Vorderseitendeckschicht auch nach bereits erfolgter Ausbildung der Kontaktschichtgitterstruktur abgeschieden werden, ohne dass eine nachfolgende Abätzung der Vorderseitendeckschicht von der Kontaktschichtgitterstruktur erforderlich ist. Es kann also eine vollständige Metallisierung der Solarzelle vorgenommen werden und danach auf die gesamte Solarzelle die feuchtigkeitssperrende, elektrisch nicht leitfähige, transparente dielektrische Vorderseitendeckschicht abgeschieden werden, welche die Vorderseitenelektrodenschicht versiegelt.

Eine solche Oberflächenselektivität bei der Abscheidung ist bei anderen Schichtabscheideverfahren, wie der Atomlagenbeschichtung (ALD), dem Sputtern oder bei Bedampfungsverfahren, nicht erreichbar.

Dabei kommen bei der vorliegenden Erfindung als Vorderseitendeckschicht beispielsweise SiO/N-Schicht(en) in Betracht, die bei Solarzellen üblicherweise bereits als Antireflex- und Passivierschichten zum Einsatz kommen. Feuchteaffine AlOₓ-Schichten sind hingegen weniger als Vorderseitendeckschicht geeignet, können aber beispielsweise als obere Schichtlage einer aus einer Siliziumoxid- und einer Aluminiumoxid bestehenden Vorderseitendeckschicht vorteilhaft zur Feuchteaufnahme und damit als Barriereschicht vor Feuchtigkeit gegenüber der darunter liegenden Siliziumoxidschicht eingesetzt werden.

Das PECVD-Verfahren, das erfindungsgemäß zur Ausbildung der Vorderseitendeckschicht verwendet wird, hat zudem den Vorteil, dass es im Niedertemperaturbereich, also bei Temperaturen ≤ 200 °C, funktioniert, wodurch sich das erfindungsgemäße Verfahren insbesondere auch zur Anwendung bei temperaturempfindlichen Solarzellen, wie Heterojunction-Solarzellen mit amorphen, nano- und/oder mikrokristallinen Silizium-Oberflächenpassivierungsschichten eignet.

Eine solche Feuchtigkeitssperre kann gemäß einer Ausführungsform der vorliegenden Erfindung auch auf der Solarzellenrückseite vorgesehen werden. Dabei weist das Ausbilden der Rückseitenmetallisierung folgende Schritte auf: Ausbilden einer rückseitigen metallischen Kontaktschichtgitterstruktur zur elektrischen Kontaktierung des Rückseitenemitters oder der Rückseitenoberflächenfeldlage; rückseitige PECVD-Abscheidung einer elektrisch nicht leitfähigen, transparenten dielektrischen Rückseitendeckschicht nach Ausbilden der rückseitigen Kontaktschichtgitterstruktur; wobei für die Abscheidung der Rückseitendeckschicht eine oberflächenselektive PECVD-Abscheidung verwendet und die Rückseitendeckschicht mit einer solchen Dicke abgeschieden wird, dass die Rückseitendeckschicht direkt nach ihrer Schichtabscheidung, ohne zusätzliche Wärme- und/oder chemische Behandlung nur auf den die rückseitige Kontaktschichtgitterstruktur umgebenden Bereichen, aber nicht auf der rückseitigen Kontaktschichtgitterstruktur eine geschlossene Schicht ausbildet.

Somit ist das erfindungsgemäße Verfahren zum Beispiel auch bei bifazialen Solarzellen, wie beispielsweise bifazialen Heterojunction-Rückseitenemittersolarzellen, anwendbar.

Die vorder- und oder die rückseitige Kontaktschichtgitterstruktur kann zunächst als eine Keimschichtstruktur ausgebildet werden, die nachfolgend verstärkt wird. Hierfür ist in einer Variante des erfindungsgemäßen Verfahrens vorgesehen, dass auf der vorderseitigen Kontaktschichtgitterstruktur wenigstens eine vorderseitige metallische Kontaktdickenverstärkungsschicht unter Nutzung des Materials der Vorderseitendeckschicht als galvanischer Maskierungsschicht ohne vorherige Strukturierung und/oder ohne zumindest teilweise Entfernung der Vorderseitendeckschicht galvanisch abgeschieden wird, und/oder auf der rückseitigen Kontaktschichtgitterstruktur wenigstens eine rückseitige metallische Kontaktdickenverstärkungsschicht unter Nutzung des Materials der Rückseitendeckschicht als galvanischer Maskierungsschicht ohne vorherige Strukturierung und/oder zumindest teilweise Entfernung der Rückseitendeckschicht galvanisch abgeschieden wird.

Dabei wird die vorder- und/oder die rückseitige Kontaktschichtgitterstruktur zunächst als Keimschicht- oder Seed-Struktur als eine sehr dünne Metallisierungsstruktur, beispielsweise in Form von Fingern oder Busbars, auf die Oberfläche der elektrisch leitfähigen, transparenten Vorder- und/oder Rückseitenelektrodenschicht aufgebracht, wie beispielsweise gedruckt und getempert. Als Material für die Seed-Struktur kann beispielsweise eine Paste, wie eine Silberpaste, verwendet werden.

Nach dem Aufbringen der Seed-Struktur wird die Vorder- und/oder die Rückseitendeckschicht mittels PECVD-Abscheidung auf die jeweilige Solarzellenseite(n) abgeschieden. Bei dieser PECVD-Abscheidung wird, wie oben ausgeführt, die Seed-Struktur nicht bzw. nicht vollflächig beschichtet. Dadurch kann die Seed-Struktur nach der Abscheidung der Vorder- und/oder die Rückseitendeckschicht, ohne diese auf der Seed-Struktur entfernen zu müssen, beispielsweise galvanisch nachverstärkt werden. Zur galvanischen Nachverstärkung kann beispielsweise das LIP(Light Induced Plating)-Verfahren verwendet werden. Als Material für die Kontaktdickenverstärkungsschicht kommt Silber, aber auch Kupfer in Betracht. Die vorzugsweise, aber nicht ausschließlich galvanisch erzeugbare, metallische Kontaktdickenverstärkungsschicht haftet bei dieser Ausführungsform des erfindungsgemäßen Verfahrens sehr gut auf der Seed-Struktur und erhöht deren elektrische Leitfähigkeit.

Diese Variante des erfindungsgemäßen Verfahrens hat den Vorteil, dass keine SiON-Schicht als galvanische Maske zusätzlich abgeschieden werden muss, da die die Seed-Struktur umgebende, auf der elektrisch leitfähigen, transparenten Vorder- und/oder Rückseitenelektrodenschicht liegende Vorder- und/oder Rückseitendeckschicht bereits die Maskenfunktion übernimmt.

Darüber hinaus kann mit dieser Verfahrensführung eine bessere Zelleffizienz erreicht werden. So ergibt sich hierdurch die Möglichkeit, die elektrisch leitfähige, transparente Vorder- und/oder Rückseitenelektrodenschicht, die beispielsweise eine ITO-Schicht ist, dünner zu machen bzw. einen großen Teil der Dicke der Vorder- und/oder Rückseitenelektrodenschicht durch die Vorder- und/oder die Rückseitendeckschicht, also eine Si-ON-Schicht, zu ersetzen. Dadurch wird die Antireflexschicht der Solarzelle transparenter. Die Optik der Solarzelle kann dadurch sowohl im UV-Bereich, in dem die Absorption durch eine dünnere TCO-Schicht verringert wird, als auch im Infrarotbereich deutlich verbessert werden. Außerdem spart man dann, wenn als Vorder- und/oder Rückseitenelektrodenschicht ITO (Indium-Zinn-Oxid) verwendet wird, Indium.

Zudem kann mit dieser Variante des erfindungsgemäßen Verfahrens zur Herstellung der Kontaktschichtgitterstruktur verwendete Silberpaste eingespart und trotzdem eine sehr gute elektrische Leitfähigkeit der Kontaktfinger der Kontaktschichtgitterstruktur erreicht werden. Dieses Verfahren eignet sich für Modulverschaltungen mit und ohne Busbars, ohne zusätzliche Effizienzverluste zu riskieren. Trotz der erfindungsgemäß verwendeten Überbeschichtung ist eine gute Kontaktier- und/oder Lötbarkeit der Kontaktschichtgitterstruktur gegeben.

Die Vorder- und die Rückseitendeckschicht der vorliegenden Erfindung besitzen demnach Multifunktionalität. Sie können als Entspiegelungs- bzw. Reflexionsschutzschicht(en), als Korrosionsschutz- bzw. Versiegelungsschicht(en) und/oder als Maske(n) für eine galvanische Nachverstärkung von Kontaktseedstrukturen eingesetzt werden.

In zweckmäßigen Ausgestaltungen der vorliegenden Erfindung wird/werden die vorderseitige metallische Kontaktschichtgitterstruktur vor der Abscheidung der Vorderseitendeckschicht und/oder die rückseitige metallische Kontaktschichtgitterstruktur vor der Abscheidung der Rückseitendeckschicht durch Tempern verfestigt.

Besonders effektiv ist es, wenn die Ausbildung der Vorderseitendeckschicht und der Rückseitendeckschicht in einem Bearbeitungsprozess in derselben Beschichtungsvorrichtung unmittelbar nacheinander erfolgt.

Eine mikrowellengestützte PECVD-Abscheidung zur Herstellung der transparenten dielektrischen Vorderseitendeckschicht und/oder der transparenten dielektrischen Rückseitendeckschicht hat sich als besonders schonend erwiesen. Alternativ kann bei der vorliegenden Erfindung die PECVD-Abscheidung zur Herstellung der transparenten dielektrischen Vorderseitendeckschicht und/oder der transparenten dielektrischen Rückseitendeckschicht eine HF(Hochfrequenz)-PECVD, eine VHF(Ultrahochfrequenz)-PECVD oder eine PECVD unter Verwendung einer ETP(Expanding Thermal Plasma)-Quelle sein. Grundsätzlich kann jedoch auch anstelle einer PECVD zur Herstellung der transparenten dielektrischen Vorderseitendeckschicht und/oder der transparenten dielektrischen Rückseitendeckschicht eine Hotwire-CVD eingesetzt werden.

Für die Abscheidung der Vorderseitendeckschicht wird wenigstens eine SiOₓ-, SiNₓ-SiOₓN_{y}-Schicht oder eine aus einer Kombination aus wenigstens zwei der vorgenannten Materialien bestehende Schicht oder Schichtfolge verwendet.

Vorzugsweise wird für die Abscheidung der Rückseitendeckschicht wenigstens eine SiOₓ-, SiNₓ-, SiOₓN_{y}-Schicht oder eine aus einer Kombination aus wenigstens zwei der vorgenannten Materialien bestehende Schicht oder Schichtfolge verwendet.

Besonders bevorzugt wird für die Abscheidung der Vorderseitendeckschicht wenigstens eine SiOₓ-Schicht und/oder für die Abscheidung der Rückseitendeckschicht wenigstens eine SiNₓ-Schicht verwendet. So kann beispielsweise auf der Solarzellenvorderseite eine SiO₂-Schicht mit einer Dicke in einem Bereich von 70 und 100 nm als Vorderseitendeckschicht und/oder auf der Solarzellenrückseite ein SiNₓ-Schicht mit einer Dicke in einem Bereich von 80 und 120 nm als Rückseitendeckschicht aufgebracht werden.

In einer optionalen Ausbildung des erfindungsgemäßen Verfahrens wird/werden die Vorderseitendeckschicht und/oder die Rückseitendeckschicht bei der Abscheidung wenigstens teilweise mit Kohlenstoff dotiert. Beispielsweise kann eine Tetramethylsilan-Beimischung zur verwendeten Silanchemie erfolgen. Durch eine Dotierung mit Kohlenstoff kann beispielsweise die Nassätzrate bzw. eine chemische Angreifbarkeit der Vorderseitendeckschicht und/oder der Rückseitendeckschicht reduziert werden.

Bei dem erfindungsgemäßen Verfahren wird die Vorderseitendeckschicht in einem Temperaturbereich zwischen 50 °C und 250 °C, besonders bevorzugt bei Temperaturen ≤ 200 °C, abgeschieden.

Vorzugsweise wird bei dem erfindungsgemäßen Verfahren die Rückseitendeckschicht bei möglichst geringen Temperaturen, also in einem Temperaturbereich zwischen 50 °C und 250 °C, besonders bevorzugt bei Temperaturen ≤ 200 °C, abgeschieden.

Der kurzzeitige zusätzliche Temperatureintrag, beispielsweise von 150 °C bis 200 °C für 2 bis 3 min, während der PECVD verbessert die Leitfähigkeit der Kontaktfinger und deren Kontaktierung auf dem TCO. Hierdurch ergibt sich ein leichter Anstieg des Füllfaktors FF der Solarzelle, beispielsweise von + 0,5 %, und der Umwandlungseffizienz ETA der Solarzelle, beispielsweise von + 0,2 %.

Für die Ausbildung der vorderseitigen Kontaktschichtgitterstruktur wird ein Material ausgewählt, das überwiegend, das heißt zu mehr als 50 %, aus Silber oder aus Kupfer besteht und als Fingerstruktur unter Verwendung einer Paste gedruckt wird.

Für die Ausbildung der rückseitigen Kontaktschichtgitterstruktur und der wenigstens einen vorderseitigen und/oder der wenigstens einen rückseitigen Kontaktdickenverstärkungsschicht kann/können vorteilhafterweise wenigstens ein elektrisch leitfähiges Oxid, wenigstens ein Metall, wenigstens eine metallische Legierung oder eine Kombination aus wenigstens zwei der vorgenannten Materialien verwendet werden.

Für die Ausbildung der rückseitigen Kontaktschichtgitterstruktur und der wenigstens einen vorderseitigen und/oder der wenigstens einen rückseitigen Kontaktdickenverstärkungsschicht wird bei dem erfindungsgemäßen Verfahren vorzugsweise ein Material ausgewählt, das überwiegend, das heißt zu mehr als 50 %, aus Silber oder aus Kupfer besteht.

Besonders zweckmäßig ist es, wenn die die rückseitige Kontaktschichtgitterstruktur als Fingerstruktur unter Verwendung einer Paste gedruckt wird.

Bei dem erfindungsgemäßen Verfahren wird für die Ausbildung der Vorderseitenelektrodenschicht transparentes, elektrisch leitfähiges Oxid, also eine TCO-Schicht, wie beispielsweise eine ITO-Schicht, verwendet

Bevorzugt wird bei dem erfindungsgemäßen Verfahren für die Ausbildung der Rückseitenelektrodenschicht transparentes, elektrisch leitfähiges Oxid, also eine TCO-Schicht, wie beispielsweise eine ITO-Schicht, verwendet.

Um einen besonders effektiven Zellschutz vor Korrosion zu erreichen, empfiehlt es sich, wenn die Ausbildung der Vorderseitendeckschicht vollständig über die gesamte Vorderseite, einschließlich der Bedeckung der Ränder des Halbleitersubstrates, und/oder die Ausbildung der Rückseitendeckschicht vollständig über die gesamte Rückseite, einschließlich der Bedeckung der Ränder des Halbleitersubstrates, vorgenommen wird. Die damit erreichbare beidseitige, vollständige, lückenlose hermetische Versiegelung der bereits metallisierten TCO-Oberflächen der Solarzelle einschließlich des Waferrandes verhindert einen Angriff von Feuchte am TCO wirksam sowohl auf Modulebene als auch auf Zellebene. Die Folge ist keine oder eine nur sehr geringe TCO-Degradation.

Eine solche, den Rand des Halbleitersubstrates einschließende Bedeckung kann nur dann erreicht werden, wenn ein geeigneter Substratträger verwendet wird. Daher kann man einen Substratträger mit einem plattenförmigen Trägergitter, das wenigstens ein von einem Nestrahmen umgebenes hohles Trägernest zur Aufnahme jeweils eines flächigen Halbleitersubstrates aufweist, verwenden, wobei von allen Seiten des Nestrahmens Haltehaken in das Trägernest auskragen, und an jedem Haltehaken wenigstens ein Haltestift vorgesehen ist, der parallel zu einer Oberfläche des aufzunehmenden Halbleitersubstrates ausgerichtet ist.

Vorzugsweise weist das Trägergitter wenigstens zwei benachbarte, durch einen Rahmenbalken des Nestrahmens getrennte Trägernester auf, und die Haltehaken sind an an dem Rahmenbalken befestigten und beidseitig des Rahmenbalkens in jeweils eines der Trägernester ragenden Haltebügeln vorgesehen.

Bevorzugte Ausführungsformen der vorliegenden Erfindung, deren Verlauf bzw. Aufbau, Funktion und Vorteile werden im Folgenden anhand von Figuren näher erläutert, wobei die Figuren 1 bis 3 schematisch einen erfindungsgemäßen Verfahrensablauf zeigen;
- Figur 4: schematisch eine Draufsicht auf einen Substratträger zeigt; und
- Figur 5: schematisch einen Querschnitt eines Rahmenbalkens mit Haltebügel eines Substratträgers zeigt, wobei schematisch angedeutet zwei Halbleitersubstrate auf Haltestiften des Haltebügels aufliegen.

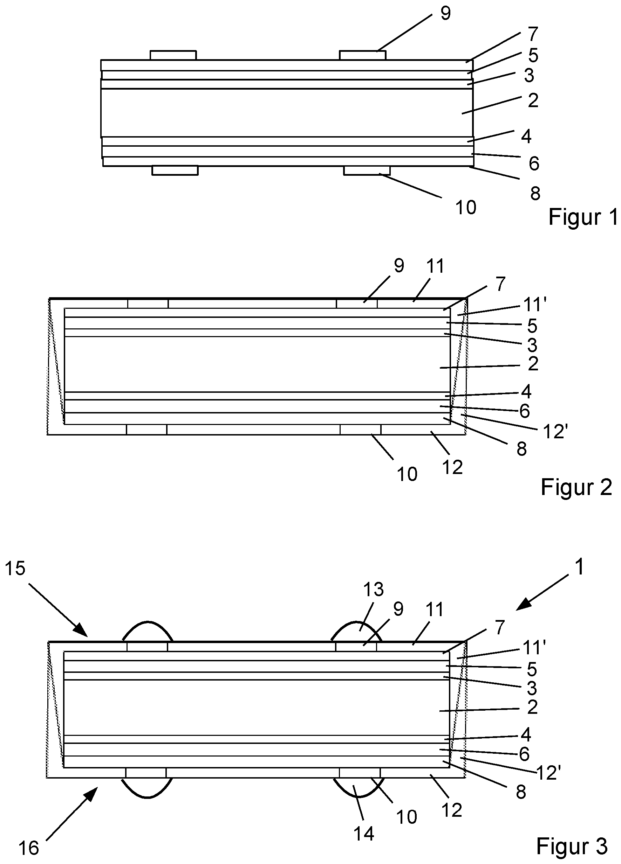

Wie es anhand von Figur 1 zu sehen ist, wird in dem erfindungsgemäßen Verfahren zunächst wenigstens ein Halbleitersubstrat 2 bereitgestellt. Das Halbleitersubstrat 2 ist von einem ersten Leitungstyp, kann also n- oder p-dotiert sein. Typischerweise, aber nicht unbedingt ist das Halbleitersubstrat 2 aus n-dotiertem Silizium ausgebildet.

Beidseitig des Halbleitersubstrates 2 sind auf diesem in der in Figur 1 gezeigten Ausführungsform intrinsische amorphe Halbleiterschichten 3, 4, in dem gezeigten Beispiel wenige Nanometer dünne i-a-Si-Schichten, vorgesehen. Anstelle der oder zusätzlich zu den intrinsischen amorphen Halbleiterschichten 3, 4 können in anderen Ausführungsformen der vorliegenden Erfindung auch intrinsische nano- und/oder mikrokristalline Halbleiterschichten, beispielsweise aus Silizium, zum Einsatz kommen.

Auf den intrinsischen amorphen Halbleiterschichten 3, 4 sind jeweils elektrisch leitfähige amorphe dotierte Halbleiterschichten 5, 6 vorgesehen. Anstelle der oder zusätzlich zu den amorphen dotierten Halbleiterschichten 5, 6 können in anderen Ausführungsformen der vorliegenden Erfindung auch nano- und/oder mikrokristalline dotierte Halbleiterschichten, beispielsweise aus Silizium, zum Einsatz kommen. In dem in Figur 1 gezeigten Ausführungsbeispiel ist auf der auf der Halbleitervorderseite befindlichen intrinsischen amorphen Siliziumschicht 3 eine p-dotierte amorphe Siliziumschicht 5, die also einen zu dem Halbleitersubstrat 2 entgegengesetzten Leitungstyp aufweist, unter Ausbildung eines Vorderseitenemitters vorgesehen. Ferner ist in dem in Figur 1 gezeigten Ausführungsbeispiel auf der auf der Halbleiterrückseite befindlichen intrinsischen amorphen Siliziumschicht 5 eine n-dotierte amorphe Siliziumschicht 6, die also den gleichen Leitungstyp wie das Halbleitersubstrat 2 aufweist, unter Ausbildung eines Rückseitenoberflächenfeldlage vorgesehen.

In anderen, nicht gezeigten Ausführungsformen der vorliegenden Erfindung kann auch auf der Vorderseite des Halbleitersubstrates 2 eine Vorderseitenoberflächenfeldlage und auf der Rückseite des Halbleitersubstrates 2 ein Rückseitenemitter vorgesehen sein.

In Figur 1 ist auf dem Vorderseitenemitter eine elektrisch leitfähige, transparente Vorderseitenelektrodenschicht 7, welche eine TCO-Schicht, wie beispielsweise eine ITO-Schicht, ist, vorgesehen. Außerdem ist auf der Rückseitenoberflächenfeldlage ebenfalls eine elektrisch leitfähige, transparenten Rückseitenelektrodenschicht 8, welche in der gezeigten Ausführungsform eine TCO-Schicht, wie beispielsweise eine ITO-Schicht, ist, vorgesehen.

Zudem ist auf der Vorderseitenelektrodenschicht 7 eine vorderseitige metallische Kontaktschichtgitterstruktur 9 zur elektrischen Kontaktierung des Vorderseitenemitters und auf der Rückseitenelektrodenschicht 8 eine rückseitige metallische Kontaktschichtgitterstruktur 10 zur elektrischen Kontaktierung der Rückseitenoberflächenfeldlage vorgesehen. Die vorderseitige und die rückseitige metallische Kontaktschichtgitterstruktur 9, 10 sind dünne, gedruckte, fingerförmige Silber-Seed-Strukturen.

Wie es in Figur 2 zu sehen ist, wird in einem nachfolgenden Verfahrensschritt ganzflächig auf die in Figur 1 gezeigte Struktur eine elektrisch nicht leitfähige, transparente dielektrische Vorderseitendeckschicht 11 mit einer PECVD-Abscheidung abgeschieden. Dabei lagert sich die Vorderseitendeckschicht 11 nur auf den die Kontaktschichtgitterstruktur 9 umgebenden Bereichen, also auf der Vorderseitenelektrodenschicht 7, nicht aber oder nur minimal auf der Kontaktschichtgitterstruktur 9 selbst ab.

Ferner wird auf der Rückseite der in Figur 1 gezeigten Struktur eine elektrisch nicht leitfähige, transparente dielektrische Rückseitendeckschicht 12 mit einer PECVD-Abscheidung abgeschieden. Dabei lagert sich die Rückseitendeckschicht 12 nur auf den die Kontaktschichtgitterstruktur 10 umgebenden Bereichen, also auf der Rückseitenelektrodenschicht 8, nicht aber oder nur minimal auf der Kontaktschichtgitterstruktur 10 selbst ab.

Das heißt, es erfolgt ein ungestörtes Schichtwachstum der Vorder- und der Rückseitendeckschicht 11, 12 auf dem TCO der Vorder- bzw. Rückseitenelektrodenschicht 7, 8, aber kein bzw. nur geringes Wachstum auf den Silberpastefingern der Kontaktschichtgitterstrukturen 9 bzw. 10. Man kann hier von einer selbstausrichtenden PECVD-Abscheidung sprechen.

Die Ausbildung der Vorderseitendeckschicht 11 erfolgt vollständig über die gesamte Vorderseite, einschließlich der Bedeckung 11' der Ränder des Halbleitersubstrates 2, und die Ausbildung der Rückseitendeckschicht 12 erfolgt vollständig über die gesamte Rückseite, einschließlich der Bedeckung 12' der Ränder des Halbleitersubstrates 2. Die Bedeckungen 11', 12' der Ränder des Halbleitersubstrates 2 verlaufen etwa keilförmig, ausgehend von der Vorderseite 15 bzw. der Rückseite 16 des Halbleitersubstrates 2 und können aneinander angrenzen oder einander überdecken.

Nach Abscheidung der Vorderseitendeckschicht 11 wird, wie in Figur 3 gezeigt, auf die vorderseitige Kontaktschichtgitterstruktur 9 galvanisch eine vorderseitige metallische Kontaktdickenverstärkungsschicht 13 unter Nutzung des Materials der Vorderseitendeckschicht 11 als galvanischer Maskierungsschicht ohne vorherige Strukturierung und/oder zumindest teilweise Entfernung der Vorderseitendeckschicht 11 abgeschieden. Außerdem wird nach Abscheidung der Rückseitendeckschicht 12, wie ebenfalls in Figur 3 zu sehen, auf die rückseitige Kontaktschichtgitterstruktur 10 galvanisch eine rückseitige metallische Kontaktdickenverstärkungsschicht 14 unter Nutzung des Materials der Rückseitendeckschicht 12 als galvanischer Maskierungsschicht ohne vorherige Strukturierung und/oder zumindest teilweise Entfernung der Rückseitendeckschicht 12 abgeschieden. Die Kontaktdickenverstärkungsschicht 13 bzw. 14 wächst typischerweise bei der Galvanik seitlich über die als Seed-Schicht verwendete Kontaktschichtgitterstruktur 9 bzw. 10 etwas hinaus.

Im Ergebnis entsteht die schematisch in Figur 3 im Querschnitt dargestellte Solarzelle 1 mit einer für einen Lichteinfall vorgesehenen Vorderseite 15 und einer gegenüber der Vorderseite 15 befindlichen Rückseite 16.

Die mit dem oben beschriebenen Verfahren hergestellte Solarzelle 1 lässt sich vor und nach der Beschichtung mit der Vorder- und der Rückseitendeckschicht 11, 12 gleich gut elektrisch kontaktieren. Die durch die Vorder- und die Rückseitendeckschicht 11, 12 ausgebildete Versiegelungsschicht bleibt vollständig intakt und muss nachträglich nicht lokal geöffnet werden, um einen elektrischen Kontakt zwischen der vorderseitigen Kontaktschichtgitterstruktur 9 und der zugehörigen Kontaktdickenverstärkungsschicht 13 sowie zwischen der rückseitigen Kontaktschichtgitterstruktur 10 und der zugehörigen Kontaktdickenverstärkungsschicht 14 herzustellen.

Zur Ausbildung der Vorder- und der Rückseitendeckschicht 11, 12 kommen bei der vorliegenden Erfindung vorzugsweise SiOₓ- und/oder SiNₓ-Schichten zum Einsatz, die optisch transparent sind und bei Wahl optimaler Schichtdicken die Entspiegelung der Solarzelle 1 sogar verbessern. So werden durch die Doppel-ARC-Funktion, wie zum Beispiel durch TCO und SiO₂, der Kurzschlussstrom I_{SC} und die Umwandlungseffizienz ETA der Solarzelle erhöht.

Grundsätzlich sind die Schritte zur Versiegelung von TCO-Schichten des erfindungsgemäßen Verfahrens auch bei Dünnfilmmodulen anwendbar.

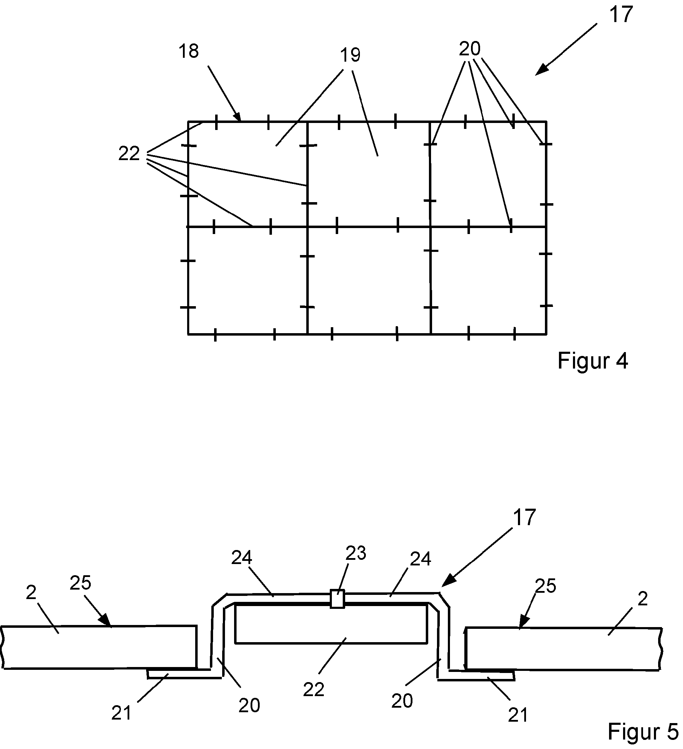

Figur 4 zeigt schematisch eine Draufsicht auf einen Substratträger 17. Der Substratträger 17 ist ein sogenannter Wafercarrier, der ein Trägergitter 18 mit mehreren in Reihen und Spalten angeordneten Trägernestern 19 aufweist. Jedes Trägernest 19 ist hierbei von einen Nestrahmen ausbildenden Rahmenbalken 22 umgeben. Die Trägernester 19 dienen jeweils der Aufnahme eines flächigen Halbleitersubstrates 2.

Von allen Seiten des Nestrahmens kragen an den Rahmenbalken 22 befestigte oder mit diesen einstückig verbundene Haltehaken 20 nach unten in das Trägernest 19 aus. Dabei ist, wie es in Figur 5 zu sehen ist, an jedem Haltehaken 20 ein Haltestift 21 vorgesehen ist, der parallel zu einer Oberfläche 25 des aufzunehmenden Halbleitersubstrates 2 ausgerichtet ist. Das Halbleitersubstrat 2 wird derart in das Trägernest 19 gelegt, dass es auf den von jedem der das Trägernest 19 umgebenden Rahmenbalken 22 ausgehenden Haltehaken 20 gehalten wird, wobei das Halbleitersubstrat 2 jeweils auf den Haltestiften 21 aufliegt.

Wie es in Figur 4 zu sehen ist, weist das Trägergitter 18 mehrere, einander benachbarte, jeweils durch einen Rahmenbalken 22 des Nestrahmens getrennte Trägernester 19 auf. Bei diesen Trägernestern 19 sind jeweils an den Rahmenbalken 22 Haltebügel 24 mit wenigstens einem Halteelement 23 derart befestigt, dass die an den Haltebügeln 24 befindlichen Haltehaken 20 mit den daran vorgesehene Haltestiften 21 in jeweils eines der Trägernester 19 ragen.

## Patentansprüche

1. Verfahren zum Herstellen einer Solarzelle (1) mit einem Heteroübergang, einer für einen Lichteinfall vorgesehenen Vorderseite (15) und einer gegenüber der Vorderseite (15) befindlichen Rückseite (16), wobei das Verfahren die folgenden Schritte aufweist:
- Bereitstellen eines kristallinen Halbleitersubstrates (2) eines ersten Leitungstyps;
- Ausbilden wenigstens einer ersten amorphen, nano- und/oder mikrokristallinen Halbleiterschicht oder -schichtfolge (3, 5) auf einer vorderseitigen Oberfläche des Halbleitersubstrates (2), entweder unter Ausbildung eines Vorderseitenemitters eines zweiten, zu dem ersten Leitungstyp entgegengesetzten Leitungstyps oder unter Ausbildung einer Vorderseitenoberflächenfeldlage des ersten Leitungstyps;
- Ausbilden wenigstens einer zweiten amorphen, nano- und/oder mikrokristallinen Halbleiterschicht oder -schichtfolge (4, 6) auf einer rückseitigen Oberfläche des Halbleitersubstrates (2), entweder unter Ausbildung einer Rückseitenoberflächenfeldlage des ersten Leitungstyps oder unter Ausbildung eines Rückseitenemitters des zweiten Leitungstyps;
- Ausbilden wenigstens einer elektrisch leitfähigen, transparenten Vorderseitenelektrodenschicht (7) auf dem Vorderseitenemitter oder der Vorderseitenoberflächenfeldlage und Ausbilden wenigstens einer elektrisch leitfähigen, transparenten Rückseitenelektrodenschicht (8) auf der Rückseitenoberflächenfeldlage oder dem Rückseitenemitter;
- Ausbilden einer vorderseitigen metallischen Kontaktschichtgitterstruktur (9) zur elektrischen Kontaktierung des Vorderseitenemitters oder der Vorderseitenoberflächenfeldlage;
- vorderseitige PECVD-Abscheidung einer elektrisch nicht leitfähigen, transparenten dielektrischen Vorderseitendeckschicht (11) nach Ausbilden der vorderseitigen Kontaktschichtgitterstruktur (9); und
- Ausbilden einer Rückseitenmetallisierung auf der Rückseitenelektrodenschicht (8);
**dadurch gekennzeichnet,**
**dass** für die Abscheidung der Vorderseitendeckschicht (11) eine oberflächenselektive PECVD-Abscheidung oder Hotwire-CVD verwendet und die Vorderseitendeckschicht (11) mit einer solchen Dicke abgeschieden wird, dass die Vorderseitendeckschicht (11) direkt nach ihrer Schichtabscheidung, ohne zusätzliche Wärme- und/oder chemische Behandlung nur auf den die vorderseitige Kontaktschichtgitterstruktur (9) umgebenden Bereichen, aber nicht auf der vorderseitigen Kontaktschichtgitterstruktur (9) eine geschlossene Schicht ausbildet, wobei die elektrisch leitfähige, transparente Vorderseitenelektrodenschicht (7) eine TCO-Schicht ist,
für die Ausbildung der vorderseitigen Kontaktschichtgitterstruktur (9) ein Material ausgewählt wird, das überwiegend aus Silber oder aus Kupfer besteht und als Fingerstruktur unter Verwendung einer Paste gedruckt wird;
für die Abscheidung der Vorderseitendeckschicht (11) wenigstens eine SiOₓ-, SiNₓ-, SiOₓN_{y}-Schicht oder eine aus einer Kombination aus wenigstens zwei der vorgenannten Materialien bestehende Schicht oder Schichtfolge verwendet wird;
die Vorderseitendeckschicht (11) unter Verwendung einer Silanchemie abgeschieden wird; und
die Vorderseitendeckschicht (11) in einem Temperaturbereich zwischen 50 °C und 250 °C abgeschieden wird.

2. Verfahren nach Anspruch 1, **dadurch gekennzeichnet, dass** das Ausbilden der Rückseitenmetallisierung folgende Schritte aufweist:
- Ausbilden einer rückseitigen metallischen Kontaktschichtgitterstruktur (10) zur elektrischen Kontaktierung des Rückseitenemitters oder der Rückseitenoberflächenfeldlage;
- rückseitige PECVD-Abscheidung einer elektrisch nicht leitfähigen, transparenten dielektrischen Rückseitendeckschicht (12) nach Ausbilden der rückseitigen Kontaktschichtgitterstruktur (10);
- wobei für die Abscheidung der Rückseitendeckschicht (12) eine oberflächenselektive PECVD-Abscheidung verwendet und die Rückseitendeckschicht (12) mit einer solchen Dicke abgeschieden wird, dass die Rückseitendeckschicht (12) direkt nach ihrer Schichtabscheidung, ohne zusätzliche Wärme- und/oder chemische Behandlung nur auf den die rückseitige Kontaktschichtgitterstruktur (12) umgebenden Bereichen, aber nicht auf der rückseitigen Kontaktschichtgitterstruktur (12) eine geschlossene Schicht ausbildet.

3. Verfahren nach Anspruch 1 oder 2, **dadurch gekennzeichnet, dass** auf der vorderseitigen Kontaktschichtgitterstruktur (9) wenigstens eine vorderseitige metallische Kontaktdickenverstärkungsschicht (13) unter Nutzung des Materials der Vorderseitendeckschicht (11) als galvanischer Maskierungsschicht ohne vorherige Strukturierung und/oder ohne zumindest teilweise Entfernung der Vorderseitendeckschicht (11) galvanisch abgeschieden wird, und/oder auf der rückseitigen Kontaktschichtgitterstruktur (10) wenigstens eine rückseitige metallische Kontaktdickenverstärkungsschicht (14) unter Nutzung des Materials der Rückseitendeckschicht (12) als galvanischer Maskierungsschicht ohne vorherige Strukturierung und/oder zumindest teilweise Entfernung der Rückseitendeckschicht (12) galvanisch abgeschieden wird.

4. Verfahren nach wenigstens einem der vorhergehenden Ansprüche, **dadurch gekennzeichnet, dass** die vorderseitige metallische Kontaktschichtgitterstruktur (9) vor der Abscheidung der Vorderseitendeckschicht (11) und/oder die rückseitige metallische Kontaktschichtgitterstruktur (10) vor der Abscheidung der Rückseitendeckschicht (12) durch Tempern verfestigt wird/werden.

5. Verfahren nach wenigstens einem der vorhergehenden Ansprüche, **dadurch gekennzeichnet, dass** die Ausbildung der Vorderseitendeckschicht (11) und der Rückseitendeckschicht (12) in einem Bearbeitungsprozess in derselben Beschichtungsvorrichtung unmittelbar nacheinander erfolgt.

6. Verfahren nach wenigstens einem der vorhergehenden Ansprüche, **dadurch gekennzeichnet, dass** die PECVD-Abscheidung zur Herstellung der transparenten dielektrischen Vorderseitendeckschicht (11) und/oder der transparenten dielektrischen Rückseitendeckschicht (12) eine mikrowellengestützte PECVD-Abscheidung, eine HF-PECVD-Abscheidung, eine VHF-PECVD-Abscheidung oder eine PECVD-Abscheidung unter Verwendung einer ETP-Quelle ist.

7. Verfahren nach wenigstens einem der vorhergehenden Ansprüche, **dadurch gekennzeichnet, dass** für die Abscheidung der Rückseitendeckschicht (12) wenigstens eine SiOₓ-, SiNₓ-, SiOₓN_{y}-Schicht oder eine aus einer Kombination aus wenigstens zwei der vorgenannten Materialien bestehende Schicht oder Schichtfolge verwendet wird.

8. Verfahren nach Anspruch 7, **dadurch gekennzeichnet, dass** für die Abscheidung der Vorderseitendeckschicht (11) wenigstens eine SiOₓ-Schicht und/oder für die Abscheidung der Rückseitendeckschicht (12) wenigstens eine SiNₓ-Schicht verwendet wird.

9. Verfahren nach Anspruch 7 oder 8, **dadurch gekennzeichnet, dass** die Vorderseitendeckschicht (11) und/oder die Rückseitendeckschicht (12) bei der Abscheidung wenigstens teilweise mit Kohlenstoff dotiert wird/werden.

10. Verfahren nach wenigstens einem der vorhergehenden Ansprüche, **dadurch gekennzeichnet, dass** die Rückseitendeckschicht (12) in einem Temperaturbereich zwischen 50 °C und 250 °C abgeschieden wird/werden.

11. Verfahren nach Anspruch 3, **dadurch gekennzeichnet, dass** für die Ausbildung der rückseitigen Kontaktschichtgitterstruktur (10) und der wenigstens einen vorderseitigen und/oder der wenigstens einen rückseitigen Kontaktdickenverstärkungsschicht (13, 14) ein Material ausgewählt wird, das überwiegend aus Silber oder aus Kupfer besteht.

12. Verfahren nach wenigstens einem der vorhergehenden Ansprüche, **dadurch gekennzeichnet, dass** die rückseitige Kontaktschichtgitterstruktur (10) als Fingerstruktur unter Verwendung einer Paste gedruckt wird.

13. Verfahren nach wenigstens einem der vorhergehenden Ansprüche, **dadurch gekennzeichnet, dass** für die Ausbildung der Vorderseitenelektrodenschicht (7) und/oder der Rückseitenelektrodenschicht (8) transparentes, elektrisch leitfähiges Oxid verwendet wird.

14. Verfahren nach wenigstens einem der vorhergehenden Ansprüche, **dadurch gekennzeichnet, dass** die Ausbildung der Vorderseitendeckschicht (11) vollständig über die gesamte Vorderseite, einschließlich der Bedeckung der Ränder des Halbleitersubstrates (2), und/oder die Ausbildung der Rückseitendeckschicht (12) vollständig über die gesamte Rückseite, einschließlich der Bedeckung der Ränder des Halbleitersubstrates (2), vorgenommen wird.

## Claims

1. Method for producing a solar cell (1) having a heterojunction, a front side (15) provided for light incidence and a rear side (16) located opposite the front side (15), the method comprising the following steps:
- providing a crystalline semiconductor substrate (2) of a first conduction type;
- forming at least one first amorphous, nano- and/or microcrystalline semiconductor layer or layer sequence (3, 5) on a front surface of the semiconductor substrate (2), either by forming a front emitter of a second conduction type which is opposite to the first conduction type or by forming a front surface field layer of the first conduction type;
- forming at least one second amorphous, nano- and/or microcrystalline semiconductor layer or layer sequence (4, 6) on a rear surface of the semiconductor substrate (2), either by forming a rear surface field layer of the first conduction type or by forming a rear emitter of the second conduction type;
- forming at least one electrically conductive, transparent front electrode layer (7) on the front emitter or the front surface field layer and forming at least one electrically conductive, transparent rear electrode layer (8) on the rear surface field layer or the rear emitter;
- forming a front metal contact layer grid structure (9) for electrically contacting the front emitter or the front surface field layer;
- front PECVD deposition of an electrically non-conductive, transparent dielectric front cover layer (11) after forming the front contact layer grid structure (9); and
- forming a rear metallization on the rear electrode layer (8);
**characterized in that**
a surface-selective PECVD deposition or hot wire CVD is used for the deposition of the front cover layer (11), and the front cover layer (11) is deposited with such a thickness that the front cover layer (11) forms a closed layer directly after its layer deposition, without additional heat and/or chemical treatment, only on the regions surrounding the front contact layer grid structure (9), but not on the front contact layer grid structure (9),
the electrically conductive, transparent front electrode layer (7) being a TCO layer,
a material consisting predominantly of silver or copper and printed as a finger structure using a paste being selected for the formation of the front contact layer grid structure (9);
at least one SiOₓ, SiNₓ, SiOₓN_{y} layer or a layer or layer sequence consisting of a combination of at least two of the aforementioned materials being used for the deposition of the front cover layer (11);
the front cover layer (11) being deposited using silane chemistry; and
the front cover layer (11) being deposited in a temperature range between 50°C and 250°C.

2. Method according to claim 1, **characterized in that** the formation of the rear metallization comprises the following steps:
- forming a rear metal contact layer grid structure (10) for electrically contacting the rear emitter or the rear surface field layer;
- rear PECVD deposition of an electrically non-conductive, transparent dielectric rear cover layer (12) after forming the rear contact layer grid structure (10);
- a surface-selective PECVD deposition being used for the deposition of the rear cover layer (12) and the rear cover layer (12) being deposited with such a thickness that the rear cover layer (12) forms a closed layer directly after its layer deposition, without additional heat and/or chemical treatment, only on the regions surrounding the rear contact layer grid structure (12), but not on the rear contact layer grid structure (12).

3. Method according to either claim 1 or claim 2, **characterized in that** at least one front metal contact thickness reinforcing layer (13) is deposited galvanically on the front contact layer grid structure (9), using the material of the front cover layer (11) as a galvanic masking layer, without prior structuring and/or without at least partial removal of the front cover layer (11), and/or at least one rear metal contact thickness reinforcing layer (14) is galvanically deposited on the rear contact layer grid structure (10), using the material of the rear cover layer (12) as a galvanic masking layer, without prior structuring and/or at least partial removal of the rear cover layer (12).

4. Method according to at least one of the preceding claims, **characterized in that** the front metal contact layer grid structure (9) is solidified by tempering before the deposition of the front cover layer (11) and/or the rear metal contact layer grid structure (10) is solidified by tempering before the deposition of the rear cover layer (12).

5. Method according to at least one of the preceding claims, **characterized in that** the formation of the front cover layer (11) and the formation of the rear cover layer (12) take place immediately one after the other in a processing process in the same coating device.

6. Method according to at least one of the preceding claims, **characterized in that** the PECVD deposition for producing the transparent dielectric front cover layer (11) and/or the transparent dielectric rear cover layer (12) is a microwave-assisted PECVD deposition, a HF-PECVD deposition, a VHF-PECVD deposition or a PECVD deposition using an ETP source.

7. Method according to at least one of the preceding claims, **characterized in that** at least one SiOₓ, SiNₓ, SiOₓN_{y} layer or a layer or layer sequence consisting of a combination of at least two of the aforementioned materials is used for the deposition of the rear cover layer (12).

8. Method according to claim 7, **characterized in that** at least one SiOₓ layer is used for the deposition of the front cover layer (11) and/or at least one SiNₓ layer is used for the deposition of the rear cover layer (12).

9. Method according to either claim 7 or claim 8, **characterized in that** the front cover layer (11) and/or the rear cover layer (12) are doped at least in part with carbon during deposition.

10. Method according to at least one of the preceding claims, **characterized in that** the rear cover layer (12) is deposited in a temperature range between 50°C and 250°C.

11. Method according to claim 3, **characterized in that** a material which consists predominantly of silver or copper is selected for the formation of the rear contact layer grid structure (10) and the at least one front and/or the at least one rear contact thickness reinforcing layer (13, 14).

12. Method according to at least one of the preceding claims, **characterized in that** the rear contact layer grid structure (10) is printed as a finger structure using a paste.

13. Method according to at least one of the preceding claims, **characterized in that** transparent, electrically conductive oxide is used for the formation of the front electrode layer (7) and/or the rear electrode layer (8).

14. Method according to at least one of the preceding claims, **characterized in that** the formation of the front cover layer (11) is carried out completely over the entire front side, including the coverage of the edges of the semiconductor substrate (2), and/or the formation of the rear cover layer (12) is carried out completely over the entire rear side, including the coverage of the edges of the semiconductor substrate (2).

## Revendications

1. Procédé de production d'une cellule solaire (1) présentant une transition hétérogène, une face avant (15) conçue pour une lumière incidente et une face arrière (16) se trouvant à l'opposé de la face avant (15), le procédé présentant les étapes suivantes :
- mise à disposition d'un substrat semi-conducteur (2) cristallin d'un premier type de conductivité ;
- formation d'au moins une première couche ou succession de couches semi-conductrice (3, 5) amorphe, nanocristalline et/ou microcristalline sur une surface avant du substrat semi-conducteur (2), soit avec formation d'un émetteur de face avant d'un deuxième type de conductivité opposé au premier type de conductivité, soit avec formation d'un emplacement de champ surfacique de face avant du premier type de conductivité ;
- formation d'au moins une deuxième couche ou succession de couches semi-conductrice (4, 6) amorphe, nanocristalline et/ou microcristalline sur une surface arrière du substrat semi-conducteur (2), soit avec formation d'un emplacement de champ surfacique de face arrière du premier type de conductivité, soit avec formation d'un émetteur de face arrière du deuxième type de conductivité ;
- formation d'au moins une couche d'électrode de face avant (7) électroconductrice, transparente sur l'émetteur de face avant ou sur l'emplacement de champ surfacique de face avant et formation d'au moins une couche d'électrode de face arrière (8) électroconductrice, transparente sur l'emplacement de champ surfacique de face arrière ou sur l'émetteur de face arrière ;
- formation d'une structure de grille de couche de contact (9) métallique sur la face avant pour la mise en contact électrique de l'émetteur de face avant ou de l'emplacement de champ surfacique de face avant ;
- dépôt par PECVD (dépôt chimique en phase vapeur assisté par plasma) sur la face avant d'une couche de recouvrement de face avant (11), non électroconductrice, transparente, diélectrique après la formation de la structure de grille de couche de contact (9) sur la face avant ; et
- formation d'une métallisation de face arrière sur la couche d'électrode de face arrière (8) ;
**caractéris en ce qu'on** utilise, pour le dépôt de la couche de recouvrement de face avant (11), un dépôt par PECVD ou un CVD par fil chaud sélectif en surface et on dépose la couche de recouvrement de face avant (11) en une épaisseur telle que la couche de recouvrement de face avant (11) forme une couche fermée directement après son dépôt de couche, sans traitement thermique et/ou chimique supplémentaire, uniquement sur les zones entourant la structure de grille de couche de contact (9) sur la face avant, mais pas sur la structure de grille de couche de contact (9) sur la face avant,
la couche d'électrode de face avant (7) électroconductrice, transparente étant une couche TCO (oxyde conducteur transparent),
un matériau qui est constitué principalement d'argent ou de cuivre et qui est imprimé en tant que structure digitale à l'aide d'une pâte étant utilisé pour la formation de la structure de grille de couche de contact (9) sur la face avant ;
au moins une couche de SiOₓ, de SiNₓ, de SiOₓN_{y} ou une couche ou succession de couches constituée par une combinaison d'au moins deux des matériaux susmentionnés étant utilisée pour le dépôt de la couche de recouvrement de face avant (11) ;
la couche de recouvrement de face avant (11) étant déposée à l'aide d'une chimie basée sur les silanes ; et
la couche de recouvrement de face avant (11) étant déposée dans une plage de température entre 50 °C et 250 °C.

2. Procédé selon la revendication 1, **caractérisé en ce que** la formation de la métallisation de face arrière présente les étapes suivantes :
- formation d'une structure de grille de couche de contact (10) métallique sur la face arrière pour la mise en contact électrique de l'émetteur de face arrière ou de l'emplacement de champ surfacique de face arrière ;
- dépôt par PECVD sur la face arrière d'une couche de recouvrement de face arrière (12), non électroconductrice, transparente, diélectrique après la formation de la structure de grille de couche de contact (10) sur la face arrière ;
- où, pour le dépôt de la couche de recouvrement de face arrière (12), on utilise un dépôt par PECVD sélectif en surface et la couche de recouvrement de face arrière (12) est déposée en une épaisseur telle que la couche de recouvrement de face arrière (12) forme une couche fermée directement après son dépôt de couche, sans traitement thermique et/ou chimique supplémentaire, uniquement sur les zones entourant la structure de grille de couche de contact (12) sur la face arrière, mais pas sur la structure de grille de couche de contact (12) sur la face arrière.

3. Procédé selon la revendication 1 ou 2, **caractérisé en ce qu'on** dépose par galvanisation, sur la structure de grille de couche de contact (9) sur la face avant, au moins une couche de renforcement d'épaisseur de contact (13) métallique sur la face avant en utilisant le matériau de la couche de recouvrement de face avant (11) en tant que couche de masquage galvanique sans structuration préalable et/ou sans élimination au moins partielle de la couche de recouvrement de face avant (11) et/ou on dépose par galvanisation, sur la structure de grille de couche de contact de face arrière (10) au moins une couche de renforcement d'épaisseur de contact (14) métallique sur la face arrière en utilisant le matériau de la couche de recouvrement de face arrière (12) en tant que couche de masquage galvanique sans structuration préalable et/ou élimination au moins partielle de la couche de recouvrement de face arrière (12).

4. Procédé selon au moins l'une quelconque des revendications précédentes, **caractérisé en ce que** la structure de grille de couche de contact (9) métallique sur la face avant est consolidée par recuisson avant le dépôt de la couche de recouvrement de face avant (11) et/ou la structure de grille de couche de contact (10) métallique sur la face arrière est consolidée par recuisson avant le dépôt de la couche de recouvrement de face arrière (12).

5. Procédé selon au moins l'une quelconque des revendications précédentes, **caractérisé en ce que** la formation de la couche de recouvrement de face avant (11) et la formation de la couche de recouvrement de face arrière (12) ont lieu de manière directement consécutive dans un processus de traitement dans le même dispositif de revêtement.

6. Procédé selon au moins l'une quelconque des revendications précédentes, **caractérisé en ce que** le dépôt par PECVD pour la production de la couche de recouvrement de face avant (11) transparente, diélectrique et/ou de la couche de recouvrement de face arrière (12) transparente, diélectrique est un dépôt par PECVD assisté par micro-ondes, un dépôt par HF-PECVD, un dépôt par VHF-PECVD ou un dépôt par PECVD avec utilisation d'une source d'ETP (plasma thermique en expansion).

7. Procédé selon au moins l'une quelconque des revendications précédentes, **caractérisé en ce qu'**au moins une couche de SiOₓ, de SiNₓ, de SiOₓN_{y} ou une couche ou succession de couches constituée par une combinaison d'au moins deux des matériaux susmentionnés est utilisée pour le dépôt de la couche de recouvrement de face arrière (12).

8. Procédé selon la revendication 7, **caractérisé en ce que,** pour le dépôt de la couche de recouvrement de face avant (11), on utilise au moins une couche de SiOₓ et/ou, pour le dépôt de la couche de recouvrement de face arrière (12), on utilise au moins une couche de SiNₓ.

9. Procédé selon la revendication 7 ou 8, **caractérisé en ce que** la couche de recouvrement de face avant (11) et/ou la couche de recouvrement de face arrière (12) est/sont dopée(s) au moins partiellement par du carbone lors du dépôt.

10. Procédé selon au moins l'une quelconque des revendications précédentes, **caractérisé en ce que** la couche de recouvrement de face arrière (12) est/sont déposée(s) dans une plage de température entre 50 °C et 250 °C.

11. Procédé selon la revendication 3, **caractérisé en ce qu'**on choisit, pour la formation de la structure de grille de couche de contact (10) sur la face arrière et de l'au moins une couche de renforcement d'épaisseur de contact sur la face avant et/ou de l'au moins une couche de renforcement d'épaisseur de contact sur la face arrière (13, 14), un matériau qui est principalement constitué d'argent ou de cuivre.

12. Procédé selon au moins l'une quelconque des revendications précédentes, **caractérisé en ce que** la structure de grille de couche de contact (10) sur la face arrière est imprimée en tant que structure digitale à l'aide d'une pâte.

13. Procédé selon au moins l'une quelconque des revendications précédentes, **caractérisé en ce qu'**on utilise, pour la formation de la couche d'électrode de face avant (7) et/ou la couche d'électrode de face arrière (8), un oxyde électroconducteur, transparent.

14. Procédé selon au moins l'une quelconque des revendications précédentes, **caractérisé en ce que** la formation de la couche de recouvrement de face avant (11) est réalisée complètement sur toute la face avant, y compris le recouvrement des bords du substrat semi-conducteur (2), et/ou la formation de la couche de recouvrement de face arrière (12) est réalisée complètement sur toute la face arrière, y compris le recouvrement des bords du substrat semi-conducteur (2).
